# EUROPEAN PATENT APPLICATION

(11) **EP 1 091 023 A2**
(43) Date of publication of application: **11.04.2001**
(21) Application number: 00308824.2
(22) Date of filing: 06.10.2000
(51) Int. Cl.: C25D 3/60, C25D 3/58

(54) **Alloy composition and plating method**

(30) Priority: 08.10.1999 US 158297 P; 10.12.1999 US 460327
(71) Applicant: Shipley Company LLC, Marlborough, MA 01752 (US)
(72) Inventor: Schetty, III, Robert A., Fort Salonga, NY 11768 (US); Toben, Michael P., Smithtown, NY 11787 (US); Martin, James L., Merrick, NY 11566 (US); Brown, Neil D., Merrick, NY 11566 (US); Withlaw, Keith J., Buxton, Derbyshire SK17 9DJ (GB); Crosby, Jeffrey N., Buxton, Derbyshire SK17 9RH (GB)
(74) Representative: Kent, Venetia Katherine

(57) **Abstract**

Disclosed are electrolyte compositions for depositing tin-copper alloys that are substantially free of lead. Also disclosed are methods of plating tin-copper alloys that are substantially free of lead on substrates and uses for such plated substrates.

## Description

### Background of the Invention

This invention relates generally to the field of metal alloys useful for metal plating. In particular, the present invention relates to tin-copper alloys for electronic applications.

Tin and tin-lead alloy deposits are useful for the electronics industry, particularly in the manufacture of printed wiring boards, electrical contacts and connectors, semi-conductors, electrical conduit and other related parts where the inherent properties of these deposits are necessary. Electroplating methods for depositing tin, tin-lead and other tin containing alloys are well known and many electrolytes have been proposed for electroplating such metals and/or alloys. For example, US Patent No. 4,880,507 (Toben et al.) discloses an electrolyte, system and process for depositing tin, lead or a tin-lead alloy by high speed electroplating.

The electronics industry is continuously looking for alternatives to lead as the toxic properties of this material are well known and its use may be regulated in the future. The challenge to the industry has been finding suitable replacements for tin-lead alloys that possess the same or similar properties. Once such replacements are found, electroplating processes capable of codepositing the alloying metals in just the right proportions to impart the desired properties must be developed.

The melting temperature and compositions, typically the eutectic composition, of the alloys used for such applications in the electronics industry is critical. For example, the composition of solders must be effectively controlled or else the solder may melt at too high or too low a temperature, resulting in either a temperature too high for printed wiring boards to withstand or incomplete formation of the solder joint. It is also important that any metal or alloy deposit on the components have good solderability and be able to withstand the solder temperatures used. It is also advantageous that such metal or alloy deposit form a good solder joint with tin-lead solder and lead-free solders.

Known lead-free alloys suffer from one or more deficiencies that limit their applicability to the electronics industry. Such deficiencies include: a eutectic temperature that is either too high or too low, and high cost due to expensive components, such as indium. Other lead-free alloys have typically been used as solders, but not as finishes for electronic components. For example, numerous lead-free solder pastes are known, such as tin-silver, tin-silver-copper, tin-silver-antimony-copper and tin-copper. However, such paste compositions have not been used for preparing electrolyte compositions for electroplating.

Tin-copper alloys are known to be electroplated. For example, Soviet Union Patent Application 377 435 A discloses a copper-tin alloy that is electrolytically deposited from a bath containing 21 to 25 g/L copper (I) cyanide, 56 to 65 g/L potassium cyanide (total), 26 to 28 g/L potassium cyanide (free), 56 to 62 g/L sodium stannate, 9 to 10 g/L sodium hydroxide and 0.04 to 0.2 g/L 3-methylbutanol. This bath contains 15 to 17.8 g/L copper and 25 to 27.6 g/L tin and has a pH of 12.8 to 13.2. This electrolyte composition has a very high cyanide concentration which is dangerous to handle. The resulting alloy also has a high copper concentration and does not provide a eutectic tin-copper alloy.

Soviet Union Patent Application 305 206 A discloses highly adherent copper-tin alloy coatings deposited from an electrolyte consisting of 15 to 35 g/L copper pyrophosphate, 20 to 35 g/L sodium stannate, 170 to 240 g/L potassium pyrophosphate and 5-17 g/L potassium nitrate. This bath contains 6.3 to 14.7 g/L copper and 8.9 to 15.6 g/L tin and has a pH of 10 to 11. The resulting alloy also has a high copper concentration and does not provide a eutectic tin-copper alloy.

There is thus a continuing need for tin alloys having a high concentration of tin, particularly for eutectic tin-copper alloys, that do not contain lead, avoid high cyanide concentrations, that have good mechanical properties, are easily solderable, and that can be easily electrolytically deposited.

### Summary of the Invention

It has been surprisingly found that tin-copper alloys that are substantially free of lead may be successfully plated using the electrolyte compositions of the present invention. Such tin-copper alloys produced from the electrolyte compositions of the present invention have the advantage of lower melting point combined with good mechanical and electrical properties as well as resistance to tin whisker formation.

In a first aspect, the present invention provides an electrolyte composition for depositing a tin-copper alloy on a substrate, including 5 to 100 g/L tin, 0.01 to 10 g/L copper, one or more acidic electrolytes and optionally one or more additives, wherein the composition is substantially free of lead.

In a second aspect, the present invention provides a method for depositing a tin-copper alloy on a substrate including the steps of contacting the substrate with the electrolyte composition described above and passing a current through the electrolyte to deposit the tin-copper alloy on the substrate, wherein the alloy is substantially free of lead.

In a third aspect, the present invention provides a substrate having a tin-copper alloy deposited thereon according to the process described above.

In a fourth aspect, the present invention provides a substrate including an alloy including 0.01 to 20 wt% copper and 80 to 99.99 wt% tin, wherein the alloy is substantially free of lead.

In a fifth aspect, the present invention provides a method for high speed electroplating of tin-copper alloys including the steps of a) utilizing high speed electroplating equipment comprising an electroplating cell; an overflow reservoir adjacent the cell; means for returning solution from the reservoir to the electroplating cell; means for directing a substrate to be plated from an entry point at one end of the cell to an exit at a second end of the cell; b) introducing an electrolyte including a basis solution of 5 to 100 g/L tin, 0.01 to 10 g/L copper, one or more acidic electrolytes, and optionally one or more additives, wherein the basis solution is substantially free of lead; and c) continuously electroplating substrates with tin-copper alloy at a sufficient current density and at a sufficient temperature for high speed electroplating as the substrates pass through the electroplating solution within the cell.

In a sixth aspect, the present invention provides a method for depositing a tin-copper alloy including the steps of a) contacting a printed wiring board with an electrolyte composition including 5 to 100 g/L tin, 0.01 to 10 g/L copper, one or more acidic electrolytes and optionally one or more additives, wherein the electrolyte is substantially free of lead and b) passing a current through the electrolyte to deposit the tin-copper alloy on the printed wiring board.

In a seventh aspect, the present invention provides a printed wiring board including a tin-copper alloy deposited thereon, wherein the alloy is substantially free of lead.

In an eighth aspect, the present invention provides an electronic apparatus including a printed wiring board including a tin-copper alloy deposited thereon, as described above.

### Detailed Description of the Invention

As used throughout this specification, the following abbreviations shall have the following meanings, unless the context clearly indicates otherwise: C = Centigrade; F = Fahrenheit; g = gram; mL = milliliter; L = liter; wt% = percent by weight; ppm = parts per million; µm = micron; and ASF = amps per square foot. The terms "depositing" and "plating" are used interchangeably throughout this specification. "Halide" refers to fluoride, chloride, bromide and iodide. All percentages are by weight, unless otherwise noted. All numerical ranges are inclusive.

The electrolyte compositions of the present invention include 5 to 100g/L tin, 0.01 to 10 g/L copper, one or more acidic electrolytes, and optionally one or more additives to enhance the efficiency and/or quality of the plating. The electrolyte compositions and tin-copper alloys of the present invention are substantially free of lead, and preferably free of lead. By "substantially free of lead" is meant that the electrolyte composition and the tin-copper alloy of the present invention contain less than about 50 ppm of lead. The electrolyte compositions of the present invention are preferably substantially free of cyanide, and more preferably free of cyanide. The electrolyte compositions of the present invention are also preferably substantially free of pyrophosphate, and more preferably free of pyrophosphate.

The tin useful in the present invention may be in the form of any solution soluble tin compound. Suitable tin compounds include, but are not limited to salts, such as tin halides, tin sulfates, tin alkane sulfonate, tin alkanol sulfonate, and the like, and acids. When tin halide is used, it is preferred that the halide is chloride. It is preferred that the tin compound is tin sulfate, tin chloride or tin alkane sulfonate, and more preferably tin sulfate or tin methane sulfonate. The tin compounds useful in the present invention are generally commercially available or may be prepared by methods known in the literature.

The amount of tin compound useful in the electrolyte compositions of the present invention is any amount that provides a tin content typically in the range of 5 to 100 g/L, and preferably 10 to 70 g/L. When the composition of the present invention is used in a non-high speed plating process, the amount of tin present in the electrolyte composition is typically in the range of 5 to 40 g/L, and preferably 10 to 20 g/L. When the composition of the present invention is used in a high speed plating process, the amount of tin present in the electrolyte composition is typically in the range of 20 to 100 g/L, and preferably 50 to 70 g/L. Mixtures of tin compounds may also be used advantageously in the present invention.

The copper useful in the present invention may be in the form of any solution soluble copper compound. Suitable copper compounds include, but are not limited to copper halides, copper sulfate, copper alkane sulfonate, copper alkanol sulfonate, and the like. When copper halide is used, it is preferred that the halide is chloride. It is preferred that the copper compound is copper sulfate, copper alkane sulfonate or mixtures thereof, and more preferably copper Sulfate, copper methane sulfonate or mixtures thereof. The copper compounds useful in the present invention are generally commercially available or may be prepared by methods known in the literature.

The amount of copper compound useful in the electrolyte compositions of the present invention is any amount that provides a copper content typically in the range of 0.01 to 10 g/L, and preferably 0.02 to 5 g/L. When the composition of the present invention is used in a non-high speed plating process, the amount of copper present in the electrolyte composition is typically in the range of 0.01 to 5 g/L, and preferably 0.02 to 2 g/L. When the composition of the present invention is used in a high speed plating process, the amount of copper present in the electrolyte composition is typically in the range of 0.5 to 10 g/L, and preferably 0.5 to 5 g/L. Mixtures of copper compounds may be used advantageously in the present invention.

Any acidic electrolyte that is solution soluble and does not otherwise adversely affect the electrolyte composition may be used advantageously in the present invention Suitable acidic electrolytes include, but are not limited to alkane sulfonic acids, such as methane sulfonic acid, sulfuric acid, sulfamic acid, hydrochloric acid, hydrobromic acid and fluoroboric acid. The acidic electrolytes useful in the present invention are generally commercially available or may be prepared by methods known in the literature.

Typically, the amount of acidic electrolyte is in the range of 10 to 400 mL/L, and preferably 100 to 200 mL/L. It is preferred that when the tin compound and/or copper compound is a halide that the acidic electrolyte is the corresponding acid. For example, when tin chloride and copper chloride are used in the present invention, it is preferred that the acidic electrolyte is hydrochloric acid. It will be appreciated by those skilled in the art that mixtures of acidic electrolytes may also be used in the present invention.

Electroplating baths containing the electrolyte compositions of the present invention are typically prepared by adding to a vessel one or more acidic electrolytes, followed by one or more tin compounds and one or more copper compounds, and then one or more other additives. Other orders of addition of the components of the compositions of the present invention may be used. Once the bath is prepared, undesired material is removed, such as by filtration, and then water is added to adjust the final volume of the bath. The bath may be agitated by any known means, such as stirring, swirling or shaking, for increased plating speed.

The electrolyte compositions of the present invention and plating baths prepared therefrom typically are acidic, i.e. having a pH of less than 7, typically less than 1. An advantage of the electrolyte compositions of the present invention is that pH adjustment of the electroplating bath is not necessary. However, if a composition of a specific pH is desired, such as in the range of 2.5 to 4.5, then adjustment of the pH is necessary. Such pH adjustment may be by any known methods, such as the addition of base or use of lesser amounts of acidic electrolyte. Such electrolyte compositions of the present invention having a pH of in the range of 2.5 to 4.5 are particularly suited for use in the plating of components containing pH-sensitive materials such as, for example, glass or ceramic capacitors and resistors.

The electrolyte compositions of the present invention are useful in any plating method where a tin-copper alloy is desired. Suitable plating methods include, but are not limited to barrel plating and high speed plating. A tin-copper alloy may be deposited on a substrate by the steps of contacting the substrate with the electrolyte composition described above and passing a current through the electrolyte to deposit the tin-copper alloy on the substrate. Any substrate that can be electrolytically plated with a metal is suitable for plating according to the present invention. Suitable substrates include, but are not limited to; copper, copper alloys, nickel, nickel alloys, nickel-iron containing materials, electronic components, plastics, and the like. Suitable plastics include plastic laminates, such as printing wiring boards, particularly copper clad printed wiring boards. The electrolyte compositions of the present invention are particularly suitable for electroplating of electronic components, such as lead frames, semiconductor packages, components, connectors, contacts, chip capacitors, chip resistors, printed wiring boards, and the like.

The substrate may be contacted with the electrolyte composition in any manner known in the art. Typically, the substrate is placed in a bath containing the electrolyte composition of the present invention.

Typically, the current density used to plate the tin-copper alloy of the present invention is in the range of, but not limited to, 1 to 2000 ASF. When a non-high speed electroplating process is used, the current density is typically in the range of 1 to 40 ASF, and preferably 1 to 30 ASF.

Typically, the tin-copper alloy of the present invention may be deposited at a temperature in the range of, but not limited to, 60° to 150° F (15° to 66° C) or higher, and preferably 70° to 125° F (21° to 52° C), and more preferably 75° to 120° F (23° to 49° C). When a non-high speed electroplating process is used, the temperature is preferably about 70° to 75° F (21° to 25° C). It will be appreciated by those skilled in the art that lower plating temperatures are typically used with low speed, or non-high speed, plating systems and/or the use of brighteners. It will also be appreciated by those skilled in the art that higher temperatures are used with high speed plating systems.

For example, when the electrolyte compositions of the present invention are used to deposit a tin-copper alloy on a copper clad printed wiring board, a suitable current density is 20 ASF. The length of time the printed wiring board remains in the electroplating bath is not critical, but typically is 8 to 10 minutes at 20 ASF. The resulting tin-copper alloy plated on the printed wiring board is typically 7 to 8 µm in thickness.

In general, the length of time a substrate remains in a plating bath containing the electrolyte compositions of the present invention is not critical. Longer times typically result in thicker deposits while shorter times typically result in thinner deposits, for a given temperature and current density. Thus, the length of time a substrate remains in a plating bath may be used to control the thickness of the resulting alloy deposit.

The electrolyte compositions of the present invention may be used to deposit tin-copper alloys containing 0.01 to 20 wt% copper and 80 to 99.99 wt% tin, based on the weight of the alloy, as measured by either atomic adsorption spectroscopy ("AAS") or inductively coupled plasma ("ICP"). It is preferred that the tin-copper alloy be the eutectic mixture, i.e. 99.3% tin and 0.7% copper. Such tin-copper alloys are substantially free of lead, and preferably free of lead.

A further advantage of the electrolyte compositions of the present invention is that they may be successfully used to deposit tin-copper alloy in a high speed electroplating process. The term "high speed electroplating" refers to those processes which operate at a current density about 50 ASF or greater using the above described equipment. Typical current densities are in the range of 50 to 2000 ASF or higher, preferably 100 to 1500 ASF, and more preferably 200 to 500 ASF. Typically, such processes also operate above a temperature of about 70° F (21° C). Suitable temperatures include, but are not limited to, those in the range of 70° to 140° F (21° to 60° C) or higher, preferably greater than 85° F (29° C), and more preferably greater than 95° F (35° C).

Such a method for high speed electroplating of tin-copper alloys includes the steps of: a) utilizing high speed electroplating equipment comprising an electroplating cell; an overflow reservoir adjacent the cell; means for returning solution from the reservoir to the electroplating cell; means for directing a substrate to be plated from an entry point at one end of the cell to an exit at a second end of the cell; b) introducing an electrolyte including a basis solution of 5 to 100 g/L tin, 0.01 to 10 g/L copper, one or more acidic electrolytes, and optionally one or more additives, wherein the basis solution is substantially free of lead; and c) continuously electroplating substrates with tin-copper alloy at a sufficient current density and at a sufficient temperature for high speed electroplating as the substrates pass through the electroplating solution within the cell.

The returning means may be any known means, such as tubes, hoses, conduits, pumps, drains and the like. The directing means may be any known means, such as conveyors, belts, rollers, robot arms and the like.

The high speed electroplating process of the present invention may be performed using any of a variety of high speed electroplating equipment. Such high speed electroplating equipment is well known to those skilled in the art, such as, for example, that disclosed in US Pat. No. 3,819,502, herein incorporated by reference to the extent it teaches such equipment.

Another advantage of the electrolyte compositions and electroplating methods of the present invention is that tin-copper alloys, particularly eutectic tin-copper alloy, may be plated at generally the same speed as corresponding 100% tin systems. Thus, the compositions and methods of the present invention may be used advantageously without any increase in the plating time required as compared to all tin plating processes. Another advantage of the electrolytes of the present invention is that they are 100% efficient.

An advantage of the tin-copper alloy compositions of the present invention is that they have a lower melting point combined with good mechanical and electrical properties as well as resistance to tin whisker formation.

It will be appreciated by those skilled in the art that one or more other additives may be combined with the electrolyte composition of the present invention, such as other alloying materials, reducing agents, wetting agents, brightening agents and the like. Mixtures of additives may also be used in the present invention.

Suitable other alloying materials that may be used in the present invention include, but are not limited to: zinc, bismuth, indium or antimony. Such other alloying materials may be used, for example, to slightly modify the melting range of the tin-copper alloy. The amounts of such other alloying materials are well known to those skilled in the art and may be any amount that provides the desired properties. Such other alloying materials are typically present in an amount of less than 1%, and preferably less than 0.5%. However, greater amounts may be used advantageously in the present invention.

Reducing agents may be added to the electrolyte composition of the present invention to assist in keeping the tin in a soluble, divalent state. Suitable reducing agents include, but are not limited to, hydroquinone and hydroxylated aromatic compounds, such as resorcinol, catechol, and the like.

Suitable wetting agents are any which yield deposits having good solderability, good matte or lustrous finish with satisfactory grain refinement, are stable in the acidic electroplating bath, electroplate at high speeds, provide little or no foam to the bath during the electroplating process, and provide a cloud point of the bath above about 110° F (43° to 44° C). Suitable wetting agents include, but are not limited to: relatively low molecular weight ethylene oxide ("EO") derivatives of aliphatic alcohols containing an alkyl group of up to 7 carbons or ethylene oxide derivatives of aromatic alcohols having up to two aromatic rings, which may be fused and which may be substituted with an alkyl group having up to 6 carbons. The aliphatic alcohols may be saturated or unsaturated. The aromatic alcohols typically have up to 20 carbon atoms prior to derivatization with ethylene oxide. Such aliphatic and aromatic alcohols may be further substituted, such as with sulfate or sulfonate groups. Suitable wetting agents include, but are not limited to: polystyrenated phenol with 12 moles of EO, butanol with 5 moles of EO, butanol with 16 moles of EO, butanol with 8 moles of EO, octanol with 12 moles of EO, beta-naphthol with 13 moles of EO, bisphenol A with 10 moles of EO, sulfated bisphenol A with 30 moles of EO and bisphenol A with 8 moles of EO. Typically, such wetting agents are added in an amount of 0.1 to 15 mL/L, and preferably 0.5 to 10 mL/L.

Bright deposits may be obtained by adding brighteners to the electrolyte compositions of the present invention. Such brighteners are well known to those skilled in the art. Suitable brighteners include, but are not limited to aromatic aldehydes, such as chlorobenzaldehyde, or derivatives thereof, such as benzal acetone. The amounts of such additives are well known to those skilled in the art.

It will be appreciated by those skilled in the art that other compounds may be added to the electrolyte compositions of the present invention to provide further grain refinement. Such other compounds may be added to the electrolyte composition of the present invention to further improve deposit appearance and operating current density range. Such other compounds include, but are not limited to: alkoxylates, such as the polyethoxylated amines JEFFAMINE T-403 or TRITON RW, or sulfated alkyl ethoxylates, such as TRITON QS-15, and gelatin or gelatin derivatives. The amounts of such other compounds useful in the compositions of the present invention are well known to those skilled in the art and typically are in the range of 0.1 to 20 mL/L, preferably 0.5 to 8 mL/L, and more preferably 1 to 5 mL/L.

In another embodiment, acetaldehyde or glutaraldehyde may be added to the compositions of the present invention to increase the high current density of the plating bath. The amount of acetaldehyde or glutaraldehyde added is that amount sufficient to raise the useful current density to the desired level. Typically, acetaldehyde or glutaraldehyde is used at an amount of 0.5 to 3 g/L, and preferably 1 to 2 g/L.

Which optional additives, if any, are added to the electrolyte compositions of the present invention depends upon the results and types of deposits desired. It will be clear to one skilled in the art which additives and in what amounts are needed to achieve the desired finished alloy.

A further advantage of the tin-copper alloys of the present invention is that they are easily solderable. Thus, any solder may be used. Suitable solders include, but are not limited to tin-lead solders, tin-copper solders, tin-silver solders, tin-bismuth solders, and ternary alloys thereof. It is preferred that the solder is lead free.

The following examples are intended to illustrate further various aspects of the present invention, but are not intended to limit the scope of the invention in any aspect.

### Example 1

An electrolyte composition was prepared containing 15 g/L tin from tin sulfate, 0.5 g/L copper from copper sulfate, 100 mL/L sulfuric acid and 2 mL/L polystyrenated phenol. An electrolyte bath was prepared by combining the electrolyte composition with water to provide the desired volume. A copper alloy lead frame substrate was plated by placing the substrate in the bath and treating the bath with a low current density (10 ASF) at 75° F (24° C) for approximately 20 minutes. After plating, the substrate was removed and contained a 10 µm thick tin-copper alloy deposit.

### Example 2

The procedure of Example 1 was repeated except that the electrolyte composition further included approximately 100 ppm of chlorobenzaldehyde.

### Example 3

An electrolyte composition was prepared containing 60 g/L tin as tin methane sulfonate, 1.5 g/L copper as copper methane sulfonate, 200 mL/L methane sulfonic acid and 2 mL/L ethoxylated bisphenol A. An electrolyte bath was prepared by combining the electrolyte composition with water to provide the desired volume. An iron-nickel alloy lead frame substrate was plated by placing the substrate in the bath and treating the bath with a high current density (150 ASF) at 120° F (49° C) for 1.3 minutes. After plating, the substrate was removed and contained a tin-copper alloy deposit.

### Example 4

The procedure of Example 3 was repeated except that the electrolyte composition further included approximately 100 ppm of chlorobenzddebyde.

### Example 5

An electrolyte composition is prepared by combining 15 g/L tin as tin methane sulfonic acid, 0.5 g/L copper as copper methane sulfonate, 50 g/L sodium gluconate, 18 g/L boric acid and 0.625 g/L polyethoxylated beta-naphthol. An electrolyte bath is prepared by combining the electrolyte composition with sufficient water to provide the desired volume and the pH is adjusted to 3.5. A mild steel coupon is plated by placing the coupon in the bath and applying a current density of 5 ASF at 72° F (22° C) for 20 minutes. After plating, the coupon is removed and a copper-tin alloy is deposited thereon.

### Example 6

The procedure of Example 5 is repeated except that the electrolyte composition further includes approximately 2.15 g/L of sodium cocoamphodipmpionate.

## Claims

1. An electrolyte composition for depositing a tin-copper alloy on a substrate, comprising 5 to 100 g/L tin, 0.01 to 10 g/L copper, one or more acidic electrolytes and optionally one or more additives, wherein the composition is substantially free of lead.

2. The composition of claim 1 wherein the tin is in the form of a tin compound selected from the group comprising tin halides, tin sulfates, tin alkane sulfonate, tin alkanol sulfonate and mixtures thereof.

3. The composition of claim 1 wherein the copper is in the form of a copper compound selected from the group comprising copper halides, copper sulfate, copper alkane sulfonate, copper alkanol sulfonate and mixtures thereof.

4. The composition of claim 1 wherein the acidic electrolyte is selected from the group comprising alkane sulfonic acids, sulfuric acid, sulfamic acid, hydrochloric acid, hydrobromic acid and fluoroboric acid.

5. The composition of claim 1 wherein the acidic electrolyte is present in an amount of 10 to 400 mL/L.

6. The composition of claim 1 further comprising water.

7. The composition of claim 1 wherein the additives are selected from the group comprising alloying materials, reducing agents, wetting agents, brightening agents and mixtures thereof.

8. A method for depositing a tin-copper alloy on a substrate including the steps of contacting the substrate with the electrolyte composition of claim 1 and passing a current through the electrolyte to deposit the tin-copper alloy on the substrate, wherein the alloy is substantially free of lead.

9. The method of claim 8 wherein the current used has a current density in the range of 1 to 2000 ASF.

10. The method of claim 8 wherein the substrate is selected from the group comprising copper, copper alloys, nickel, nickel alloys, nickel-iron containing materials, electronic components, and plastics.

11. The method of claim 10 wherein the electronic components are selected from the group comprising lead frames, semiconductor packages, components, connectors, contacts, chip capacitors, chip resistors, printed wiring boards.

12. A substrate having a tin-copper alloy deposited thereon according to the method of claim 8.

13. A substrate comprising an alloy comprising 0.01 to 20 wt% copper and 80 to 99.99 wt% tin, wherein the alloy is substantially free of lead.

14. A method for high speed electroplating of tin-copper alloys comprising the steps of: a) utilizing high speed electroplating equipment comprising an electroplating cell; an overflow reservoir adjacent the cell; means for returning solution from the reservoir to the electroplating cell; means for directing a substrate to be plated from an entry point at one end of the cell to an exit at a second end of the cell; b) introducing an electrolyte composition comprising a basis solution of 5 to 100 g/L tin, 0.01 to 10 g/l copper, one or more acidic electrolytes, and optionally one or more additives, wherein the basis solution is substantially free of lead; and c) continuously electroplating substrates with tin-copper alloy at a sufficient current density and at a sufficient temperature for high speed electroplating as the substrates pass through the electroplating solution within the cell.

15. A method for depositing a tin-copper alloy including the steps of a) contacting a printed wiring board with an electrolyte composition comprising 5 to 100 g/L tin, 0.01 to 10 g/L copper, one or more acidic electrolytes and optionally one or more additives, wherein the electrolyte composition is substantially free of lead and b) passing a current through the electrolyte to deposit the tin-copper alloy on the printed wiring board.

16. The method of claim 15 wherein the tin is in the form of a tin compound selected from the group comprising tin halides, tin sulfates, tin alkane sulfonate, tin alkanol sulfonate and mixtures thereof.

17. The method of claim 15 wherein the copper is in the form of a copper compound selected from the group comprising copper halides, copper sulfate, copper alkane sulfonate, copper alkanol sulfonate and mixtures thereof.

18. The method of claim 15 wherein the acidic electrolyte is selected from the group comprising alkane sulfonic acids, sulfuric acid, hydrochloric acid, hydrobromic acid and fluoroboric acid.

19. The method of claim 15 wherein the acidic electrolyte is present in an amount of 10 to 400 mL/L.

20. The method of claim 15 wherein the additives are selected from the group comprising alloying materials, reducing agents, wetting agents, brightening agents and mixtures thereof.

21. A printed wiring board comprising a tin-copper alloy deposited thereon, wherein the alloy is substantially free of lead.

22. An apparatus comprising the printed wiring board of claim 21.
